# EUROPEAN PATENT APPLICATION

(11) **EP 1 850 473 A1**
(43) Date of publication of application: **31.10.2007**
(21) Application number: 06300408.9
(22) Date of filing: 26.04.2006
(51) Int. Cl.: H03F 1/32

(54) **Method for performing linearization and image-suppression in a transmitter chain comprising a single feedback-path**

(71) Applicant: Alcatel Lucent, 75008 Paris (FR)
(72) Inventor: Pascht, Andreas, 73635 Rudersberg (DE)
(74) Representative: Brose, Gerhard

(57) **Abstract**

A method is described for performing a linearization and an image-suppression algorithm in a broadband multi-band transmitter chain (10) that comprises a broadband feedback-path (33, 34, 24) providing a broadband feedback signal, wherein said method is characterized in that said linearization and image-suppression algorithms periodically are fed with said feedback signal for the duration of individual discrete time windows, in order to provide both algorithms with individual parts of said feedback signal that are free of linearization and/or image non-conformances due to time delay of said non-conformances within said feedback signal.

Furthermore a transmitter chain (10) to be used to execute the method mentioned above, plus a base station comprising such a transmitter chain (10) is described.

## Description

The invention relates to a method for performing linearization and image-suppression in a broadband multi-band transmitter chain.

Providing new services like e.g. fast Internet access via a fixed wireless link as foreseen in the WiMAX standard requires increased data rates and due to this a broadening of the frequency bands used in wireless networks.

The mentioned changes in the frequency bands have significant impact on the hard- and software of the respective base-stations, particularly on the transmitter chains processing the signals to be transmitted. Thereby typically one transmitter chain is used to process signals of more than one frequency band. In doing so, the problem arises that a so-called multi-band signal processed by one transmitter chain shows non-conformances like particularly image non-conformances caused by upconversion-mixers within the transmitter chain as well as linearization non-conformances causing a reduced efficiency of the power amplifiers within the transmitter chain.

Arrangements for the performance of signal linearization or image-suppression functions are known which work in independent stages with individual feedback-paths comprising different components. The known arrangements are costly because they comprise at least two feedback-paths, each one comprising a plurality of costly components. Furthermore the known arrangements are large and require a lot of installation space thus raising the costs for installation site rental, with raising dimensions of a base station. An additional drawback of the known arrangements is that the efficiency of the power amplifier stage of the transmitter chain is not satisfactory due to non-conformances in linearization that result from suboptimal interaction of the algorithms within their independent stages.

The object of the invention is to find a remedy to the problems stated above and provide an improved arrangement for signal linearization and image-suppression in a broadband multi-band transmitter.

The object of the invention is met by a method for performing linearization and image-suppression in a broadband multi-band transmitter chain that comprises a single broadband feedback-path providing a broadband feedback signal, wherein according to said method the linearization and image-suppression modules are periodically fed with said feedback signal for the duration of individual discrete time windows, in order to provide both modules with individual parts of said feedback signal that are free of linearization and/or image non-conformances due to time delay of said non-conformances within said feedback signal.

A main idea of the method according to the invention is that it allows to perform signal linearization as well as image-suppression in a combined manner with a transmitter chain comprising only one feedback-path by periodically feeding said modules with parts of a feedback signal provided by said feedback-path that are free of linearization and/or image non-conformances due to time delay of said non-conformances within said feedback signal.

By the transmitter chain according to the invention the following advantages are achieved:
- Costs are saved for the installation and during operation due to an increased power amplifier efficiency.
- Costs are saved due to reduced acquisition costs caused by requiring only one combined broadband feedback-path.
- Full multi-band flexibility due to image-suppression is achieved.

Transmit signal linearization and image-suppression is preferably performed by a predistortion module and an image-suppression module respectively, both modules preferably arranged in the digital part of the transmitter chain. The feedback-path with its input is connected with a feedback-output of a power amplifier chain that is also part of the transmitter chain. On the other side, the feedback-path with its output is periodically connected with the predistortion and the image-suppression modules. Preferably the feedback-path is not only periodically but also alternately connected with those two modules. The feedback-path preferably detects, i.e. demodulates the output signal of the power amplifier chain with its inter-modulation products and the image of the signal and provides a digital feedback signal to said linearization and image-suppression modules preferably in a time-multiplex manner. To do so, the feedback-path preferably comprises a broadband down-conversion module, an analogue/digital converter and a time delay compensation module that periodically connects the feedback-path with the predistortion and the image-suppression modules.

Said method according to the invention has the advantage over the state of the art, that it allows to save installation costs as well as operation costs due to an increased power amplifier efficiency caused by linearization of the signal processed by the transmitter chain. Furthermore the method according to the invention allows reducing acquisition costs since it allows using only one combined feedback-path for feeding a linearization algorithm as well as an image-suppression algorithm, i.e. for feeding two different modules performing said algorithms. Furthermore, by performing said method according to the invention, a full multi-band flexibility is achieved due to image-suppression.

According to a preferred embodiment of the invention, said linearization and image-suppression modules are alternately fed with said feedback signal for the duration of their individual discrete time windows respectively. By alternately feeding said linearization and said image-suppression modules with the feedback signal for the duration of their individual discrete time windows, said modules are provided with said feedback signal in a time-multiplex manner.

According to another preferred embodiment of the invention, said feedback signal is clocked in discrete time intervals, wherein said individual discrete time windows during which the two modules are fed with said feedback signal have identical locations within said discrete time intervals of the clocked feedback signal. Doing so the two modules are fed with identical or at least similar parts of the feedback signal. Thereby it is possible that either both modules, during the same time interval, are synchronously fed with the same part of the feedback signal, or that both modules, during successive time intervals, are alternately fed with similar parts of the feedback signal. In both cases, the part of the feedback signal the two modules are fed with is determined by the location of the individual time windows within the time interval, i.e. by the beginning and the ending of the individual time windows within the time interval.

According to a particularly preferred embodiment of the invention, said feedback signal is clocked in discrete time intervals, wherein said individual discrete time windows during which the two modules are alternately fed with said feedback signal have different locations within said discrete time intervals of the clocked feedback signal. Doing so the two algorithms are fed with different parts of the feedback signal. Thereby it is possible that either both modules, during the same time interval, are alternately fed with the feedback signal for the duration of their individual discrete time windows, or that both modules, in successive time intervals, are alternately fed with the feedback signal for the duration of their individual discrete time windows.

Generally it is also possible that a break is foreseen between successive discrete time windows during which the modules, periodically and as the case may be alternately, are fed with the feedback signal.

Furthermore it is possible that the two algorithms are alternately fed with said feedback signal for the duration of said individual discrete time windows, wherein said discrete time windows during which said two modules are alternately fed with said feedback signal are immediately successive, wherein a break is foreseen between every pair of immediately successive discrete time windows.

Alternatively it is possible that the two modules are alternately fed with said feedback signal for the duration of said individual discrete time windows, wherein said discrete time windows during which the two modules are alternately fed with said feedback signal are overlapping, wherein a break is foreseen between every pair of overlapping discrete time windows.

According to a particularly preferred embodiment of the invention, the feedback signal the modules are fed with is a digital feedback signal.

According to another particularly preferred embodiment of the invention, time parameters defining the clocking of said time intervals of the feedback signal and/or the beginning and ending, of the individual time windows, i.e. their locations within said time intervals, are determined at least the very first time a transmitter chain used to perform said method is switched on or is prepared to be set to operation. It is also possible that said time parameters are determined whenever a transmitter chain used to perform said method according to the invention is switched on. Furthermore it is possible that said time parameters are continuously or at least periodically monitored and preferably also adjusted in order to compensate temperature and aging effects of the transmitter chain components.

Another aspect of the invention concerns a transmitter chain to be used to perform the method mentioned above, wherein said transmitter chain comprises
- a broadband feedback-path,
- means to perform a linearization function,
- means to perform an image-suppression function, and
- means to periodically connect said means to perform said linearization and said image-suppression function for the duration of discrete time windows with said broadband feedback-path in order to provide both linearization and image-suppression function means periodically with a part of a broadband feedback signal that is free of linearization and/or image non-conformances due to time delay of said non-conformances within said broadband feedback signal.

The efficiency of the power amplifier chain is a key parameter in base-station transmitter chains since it mainly affects operation costs. Therefore a combination of linearization and image-suppression is proposed to address a multi-band approach. According to the invention a broadband feedback-path is used which allows not only the detection, i.e. downconversion of the signal with intermodulation products for the linearization but also the detection of the image for the image-suppression. In the digital domain both linearization and image-suppression modules are working in time-multiplex for the update of the predistortion and image-suppression components.

A preferred embodiment of the transmitter chain according to the invention comprises means to alternately connect said means to perform said linearization and said image-suppression function for the duration of discrete time windows periodically with said broadband feedback-path.

In another preferred embodiment of the transmitter chain according to the invention said broadband feedback-path comprises means to perform a broadband down conversion of the feedback signal, means to analogue/digital convert said feedback signal plus means to perform a time delay compensation of said feedback signal.

An additional part of the invention concerns a base station comprising a transmitter chain as mentioned above.

Brief description of the drawing, with

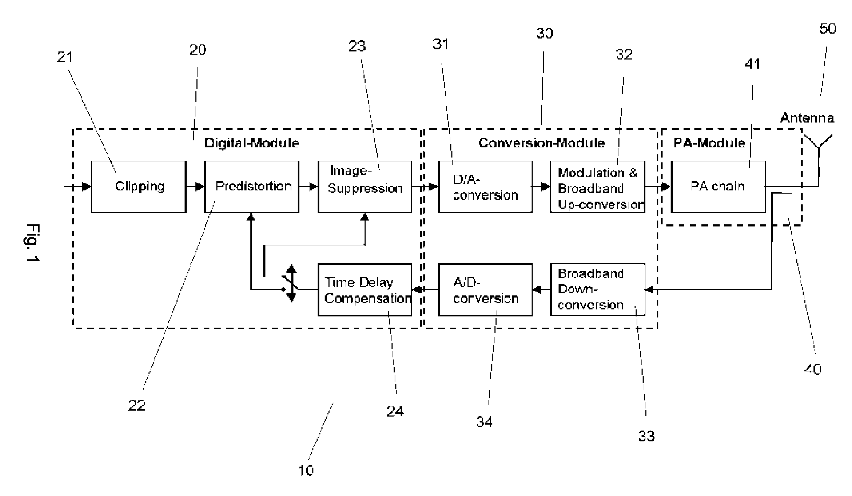

Fig. 1 showing an exemplary block diagram scheme of the architecture of an image-compensated and linearized transmitter chain according to the invention.

A transmitter chain 10 as shown in Fig. 1 basically comprises a digital module 20, a conversion module 30, a power amplifier module 40 and an antenna 50. The digital module 20 comprises a clipping module 21, a predistortion module 22, an image-suppression module 23 and a time delay compensation module 24, which provides a digital feedback signal to the predistortion module 22 and the image-suppression module 23 in a time-multiplex manner. The conversion module 30 comprises a digital/analogue converter 31, a modulation and broadband up-conversion module 32, a broadband down-conversion module 33, which detects the output power amplifier signal with its inter-modulation products and the image of the signal, and an analogue/digital converter 34. The power amplifier module 40 comprises at one or more power amplifiers that are serially arranged. In Fig. 1 a power amplifier chain 41 schematically is displayed.

The clipping module 21, the predistortion module 22, the image-suppression module 23, the digital/analogue converter 31, the modulation and broadband up-conversion module 32, the power amplifier chain 41 and the antenna 50 are serially connected with each other and together form the signal path of the transmitter chain 10.

The broadband down-conversion module 33, the analogue/digital converter 34 and the time delay compensation module 24 are serially connected with each other and together form a broadband feedback-path that is arranged parallel to the signal path described above. The feedback-path with its input, i.e. with the broadband down-conversion module 33 is connected with the output of the power amplifier chain 41. The broadband down-conversion module 33 performs the frequency conversion, the filtering and the filter adaptation. On the other side, the feedback-path with its output, i.e. with the time delay compensation module 24 alternately is connected with the predistortion module 22 and with the image-suppression module 23.

The feedback-path provides the predistortion module 22 and the image-suppression module 23 in a time-multiplex manner with a feedback signal comprising antenna signal information. After converting the feedback signal in the digital domain within the feedback-path, the predistortion module 22 and the image-suppression module 23 work in time-multiplex to realize the linearization and the image-suppression of the transmit signal respectively.

Within the predistortion module 22 linearization is performed in order to avoid non-linearity effects and linearity non-conformances causing a reduced efficiency of the power amplifier chain 41 within the transmitter chain 10. Within the image-suppression module 23 image-suppression is performed in order to avoid image non-conformances caused by the modulation and broadband up-conversion module 32 within the transmitter chain 10.

In order to be able to feed both modules 22, 23 with a feedback signal using only one feedback-path, the time delay compensation module 24, for the duration of individual time windows adapted to the requirements of the predistortion module 22 and the image-suppression module 23, alternately connects the feedback-path with those two modules 22, 23 in order to provide them with samples of the feedback signal that are free of linearization and/or image non-conformances due to time delay of said non-conformances within said broadband feedback signal.

Providing both modules 22, 23 periodically and alternately with parts of the feedback signal can also be described as time-multiplex. The time-multiplex is possible due to the fact that the effects causing non-linearities and images are quite slow. After a initialization procedure used to determine the coefficients for both algorithms the transmitter chain can be set to operation. Those coefficients to be determined during the initialization procedure are e.g. time parameters defining the conversion of the feedback signal into discrete time intervals and/or the beginning and ending of the individual time windows during which the modules 22, 23 are fed with the feedback signal and the like. During operation also temperature and aging effects are compensated.

It is important to mention that this architecture is based on a bandwidth-enhanced feedback-path. The bandwidth-enhancement of the feedback-path is necessary to detect not only the signal with its intermodulation products but also the image of the signal.

The invention is applicable particularly in the field of production and operation of transmitter equipment, transceivers and/or base stations comprising such transmitter equipment typically used to build and to operate networks for optical and/or electromagnetic data transmission as well as to build and to operate networks for wireless communication.

## Claims

1. Method for performing signal linearization and image-suppression in a broadband multi-band transmitter chain (10) that comprises predistortion and image-suppression modules (22, 23) and a broadband feedback-path (33, 34, 24) providing a broadband feedback signal, **characterized in that** said linearization and image-suppression modules (22, 23) are periodically fed with said feedback signal for the duration of individual discrete time windows, in order to provide both modules with individual parts of said feedback signal that are free of linearization and/or image non-conformances due to time delay of said non-conformances within said feedback signal.

2. Method according to claim 1, **characterized in that** said linearization and image-suppression modules (22, 23) are alternately fed with said feedback signal.

3. Method according to claim 1 or 2, **characterized in that** said feedback signal is clocked in discrete time intervals, wherein said individual discrete time windows have identical locations within said time intervals.

4. Method according to claim 3, **characterized in that** said modules (22, 23), in successive time intervals, are alternately fed with said feedback signal.

5. Method according to claim 2, **characterized in that** said feedback signal is clocked in discrete time intervals, wherein said individual discrete time windows have different locations within said time intervals.

6. Method according to claim 5, **characterized in that** said modules (22, 23), in successive time intervals, are alternately fed with said feedback signal.

7. Method according to claim 5, **characterized in that** said modules (22, 23), in the same time interval, are alternately fed with said feedback signal.

8. Method according to one of the previous claims, **characterized in that** a break is foreseen between successive discrete time windows.

9. Method according to one of the claims 1 to 7, **characterized in that** the two modules (22, 23) are alternately fed with said feedback signal for the duration of said individual discrete time windows, wherein said discrete time windows during which said two modules are alternately fed with said feedback signal are immediately successive, wherein a break is foreseen between every pair of immediately successive discrete time windows.

10. Method according to one of the claims 1 to 7, **characterized in that** the two modules (22, 23) are alternately fed with said feedback signal for the duration of said individual discrete time windows, wherein said discrete time windows during which the two modules are alternately fed with said feedback signal are overlapping, wherein a break is foreseen between every pair of overlapping discrete time windows.

11. Method according to one of the previous claims, **characterized in that** the feedback signal the modules (22, 23) are fed with is a digital feedback signal.

12. Method according to one of the previous claims, **characterized in that** time parameters defining the clocking of said time intervals and/or the beginning and ending of the individual time windows are determined at least the very first time a transmitter chain (10) used to perform said method is switched on.

13. Transmitter chain (10) **characterized by**
- a broadband feedback-path (33, 34, 24),
- means (22) to perform a linearization function,
- means (23) to perform an image-suppression function, and
- means (24) to periodically connect said linearization and image-suppression function means (22, 23) for the duration of discrete time windows with said broadband feedback-path (33, 34, 24) in order to provide both linearization and image-suppression function means periodically with a part of a broadband feedback signal that is free of linearization and/or image non-conformances due to time delay of said non-conformances within said broadband feedback signal.

14. Transmitter chain according to claim 13, **characterized by** means (24) to alternately connect said linearization and image-suppression function means (22, 23) for the duration of discrete time windows periodically with said feedback-path (33, 34, 24).

15. Transmitter chain according to claim 13 or 14, **characterized in that** said broadband feedback-path comprises means (33) to perform a broadband down conversion of the feedback signal, means (34) to analogue/digital convert said feedback signal plus means (24) to perform a time delay compensation of said feedback signal.

16. Base station comprising a transmitter chain (10) according to one of the claims 13 to 15.

## Amended claims

### Amended claims in accordance with Rule 86(2) EPC.

**1.** Method to perform signal linearization and image-suppression in a broadband multi-band transmitter chain (10) that comprises predistortion and image suppression modules (22, 23) and a broadband feedback-path (33, 34, 24) providing a broadband feedback signal, **characterized in that** said linearization and image-suppression modules (22, 23) are periodically fed with said feedback signal for the duration of individual discrete time windows, in order to provide both modules with individual parts of said feedback signal that are free of linearization and/or image non-conformances due to time delay of said non-conformances within said feedback signal during operation of the transmitter chain.

**13.** Transmitter chain (10) **characterized by**
- a broadband feedback-path (33, 34, 24),
- means (22) to perform a linearization function,
- means (23) to perform an image-suppression function, and
- means (24) to periodically connect said means (22, 23) to perform said linearization and said image-suppression function means (22, 23) for the duration of discrete time windows with said broadband feedback-path (33, 34, 24) in order to provide both linearization and image-suppression function means (22, 23) periodically with a part of a broadband feedback signal that is free of linearization and/or image non-conformances due to time delay of said non-conformances within said broadband feedback signal during operation of the transmitter chain.
